# EUROPÄISCHE PATENTSCHRIFT

(11) **EP 2 820 165 B1**
(45) Veröffentlichungstag und Bekanntmachung des Hinweises auf die Patenterteilung: **19.04.2017**
(21) Anmeldenummer: 13704721.3
(22) Anmeldetag: 16.01.2013
(51) Int. Cl.: C23C 14/00, C23C 14/06, C23C 14/24, H01M 10/0562

(54) **VERFAHREN ZUM ABSCHEIDEN EINER LIPON-SCHICHT AUF EINEM SUBSTRAT**
METHOD FOR DEPOSITING A LIPON LAYER ON A SUBSTRATE
PROCÉDÉ DE DÉPÔT D'UNE COUCHE DE LIPON SUR UN SUBSTRAT

(30) Priorität: 27.02.2012 DE 102012003594
(43) Veröffentlichungstag der Anmeldung: 07.01.2015
(73) Patentinhaber: Fraunhofer-ges. zur Förderung der Angewandten Forschung E.V., 80686 München (DE)
(72) Erfinder: GÜNTHER, Steffen, 01309 Dresden (DE); MORGNER, Henry, 01257 Dresden (DE); STRAACH, Steffen, 01187 Dresden (DE); MEYER, Björn, 01159 Dresden (DE); FAHLAND, Matthias, 01257 Dresden (DE)
(86) Internationale Anmeldenummer: PCT/EP2013/050720
(87) Internationale Veröffentlichungsnummer: WO 2013/127558

(56) Entgegenhaltungen:
- US-A1- 2009 117 289
- US-B1- 6 982 132
- KIM YOON ET AL: "Lithium phosphorous oxynitride films synthesized by a plasma-assisted directed vapor deposition approach", JOURNAL OF VACUUM SCIENCE AND TECHNOLOGY: PART A, AVS /AIP, MELVILLE, NY., US, Bd. 26, Nr. 1, 2. Januar 2008 (2008-01-02) , Seiten 174-183, XP012113825, ISSN: 0734-2101, DOI: 10.1116/1.2823491

## Beschreibung

Die Erfindung betrifft ein Verfahren zum Abscheiden einer Lithiumphosphoroxynitrid-Schicht (LiPON-Schicht) auf einem Substrat mittels physikalischer Dampfabscheidung.

### Stand der Technik

LiPON eignet sich auf Grund seiner lonenleitfähigkeit bei gleichzeitiger Nichtleitfähigkeit für Elektronen als Festkörperelektrolyt für Batterien und Akkumulatoren. In einem dafür verwendeten typischen Schichtsystem werden LiPON-Schichten mit einer Schichtdicke von etwa 1 µm bis 1,5 µm benötigt. Es ist bekannt derartige LiPON-Schichten mittels RF-Sputtern abzuscheiden (WO 99/57770 A1). Derartige Verfahren zeichnen sich jedoch durch eine geringe Beschichtungsrate und somit durch eine geringe Produktivität aus, was zu relativ teuren Produkten führt.

Es ist weiterhin bekannt, dass auch das Abscheiden von LiPON-Schichten mittels Elektronenstrahlbeschichtungsverfahren möglich ist. Dies wird beispielsweise in der Patentanmeldung US 2009/0117289 A1 offenbart; ebenso in Y.G. Kim et al J. Vac. Sci. Technol. A26(1) 2008, 174-182. Hierbei wird Lithiumphosphat (LiPO) mittels eines direkt auf das Verdampfungsmaterial einwirkenden Elektronenstrahls innerhalb einer stickstoffhaltigen Reaktivgasatmosphäre verdampft. Nachteilig wirkt sich hierbei die preisintensive und aufwendige Elektronenstrahltechnologie aus. Obwohl die Beschichtungsrate gegenüber dem RF-Sputtern dadurch gesteigert werden kann, ist auf Grund der preisintensiven Gerätetechnik ebenfalls ein hoher Produktpreis die Folge. Ein weiterer Nachteil dieses Verfahrens besteht darin, dass das direkte Verdampfen von Material mittels eines Elektronenstrahls zur Spritzerbildung neigt, die sich auch auf einem zu beschichtenden Substrat niederschlagen und somit die Schichtqualität negativ beeinflussen.

### Aufgabenstellung

Der Erfindung liegt daher das technische Problem zugrunde, ein Verfahren zum Abscheiden einer LiPON-Schicht zu schaffen, mittels dem die Nachteile des Standes der Technik überwunden werden können. Insbesondere soll es mit dem erfindungsgemäßen Verfahren möglich sein, eine LiPON-Schicht mit einer hohen Beschichtungsrate bei im Vergleich zum Stand der Technik verringertem Kostenaufwand abzuscheiden.

Die Lösung des technischen Problems ergibt sich durch Gegenstände mit den Merkmalen des Patentanspruchs 1. Weitere vorteilhafte Ausgestaltungen der Erfindung ergeben sich aus den abhängigen Patentansprüchen.

Erfindungsgemäß wird eine LiPON-Schicht auf einem Substrat abgeschieden, indem ein Verdampfungsmaterial, welches mindestens die chemischen Elemente Lithium, Phosphor und Sauerstoff umfasst, mittels einer thermischen Verdampfungseinrichtung innerhalb einer Vakuumkammer verdampft wird. Das erfindungsgemäße Verfahren grenzt sich somit auch von denjenigen Verfahren ab, bei denen ein Verdampfungsmaterial direkt mittels eines Elektronenstrahls verdampft wird. Beim erfindungsgemäßen Verfahren wird gleichzeitig mit dem thermischen Verdampfen des Verdampfungsmaterials eine stickstoffhaltige Komponente, vorzugsweise ein stickstoffhaltiges Reaktivgas, in die Vakuumkammer eingelassen und die aufsteigende Dampfpartikelwolke von einem Plasma durchdrungen. Als stickstoffhaltiges Reaktivgas eignen sich zum Beispiel Gase wie Ammoniak (NH₃), Lachgas (NO₂) oder auch Stickstoff selbst. Alternativ zum Einlassen eines stickstoffhaltigen Reaktivgases kann beispielsweise auch ein stickstoffhaltiger Precursor in die Vakuumkammer eingelassen werden. Das erfindungsgemäße Verfahren zeichnet sich durch eine für das thermische Verdampfen bekannte hohe Abscheiderate bei gleichzeitig niedrigen Produktionskosten aus.

Eine weitere Alternative zum Einlassen eines stickstoffhaltigen Reaktivgases in die Vakuumkammer kann realisiert werden, indem anstelle des Einlasses des stickstoffhaltigen Reaktivgases in die Vakuumkammer ein stickstoffhaltiges Material in der Vakuumkammer co-verdampft wird, d. h. das Verdampfungsmaterial, welches mindestens die chemischen Elemente Lithium, Phosphor und Sauerstoff umfasst, wird in einem ersten Gefäß verdampft und das stickstoffhaltige Material wird in derselben Vakuumkammer in einem separaten, zweiten Gefäß verdampft. Als stickstoffhaltiges Material, welches in einem zweiten Gefäß co-verdampft wird, kann beispielsweise LiN verwendet werden.

Zusätzliche chemische Modifikationen einer abgeschiedenen LiPON-Schicht sind durch den zusätzlichen Einlass weiterer Reaktivgase möglich. Insbesondere kann Sauerstoff verwendet werden, um das Verhältnis zwischen Stickstoff und Sauerstoff in der abgeschiedenen Schicht gezielt zu beeinflussen.

Das Verdampfen des Ausgangsmaterials wird durch das indirekte Erhitzen mittels Strahlungsheizern bewerkstelligt.

Beim erfindungsgemäßen Verfahren wird LiPO, Granulat als Verdampfungsmaterial verwendet, weil bei diesem Ausgangsmaterial nur noch eine Verbindung mit Stickstoff eingegangen werden muss, um zur gewünschten Schichtabscheidung von LiPON zu gelangen.

Vorteilhaft wird das Generieren des Plasmas mittels einer Hohlkathoden-Bogenentladung durchgeführt, weil sich damit besonders hohe Plasmadichten erzeugen lassen. Alternativ kann das Erzeugen eines Plasmas aber auch durch eine Anregung mittels Mikrowelle durchgeführt werden. Vorteilhaft wirkt sich hierbei aus, dass sich die thermische Belastung eines zu beschichtenden Substrates reduziert. Plasmen können außerdem durch eine induktive Einkopplung generiert werden, um den apparativen Aufwand noch weiter zu reduzieren.

Ferner besteht die Möglichkeit, ein Plasma durch eine magnetfeldüberlagerte Glimmentladung zu erzeugen. Dafür zur Verfügung stehende bekannte technische Systeme erlauben eine sehr homogene Plasmaausbreitung über einer großen flächigen Ausdehnung. Die Stabilität des Abscheideprozesses kann durch die Verwendung eines gepulsten Plasmas noch weiter verbessert werden, wobei die Pulstechnologie bei allen zuvor genannten Plasmaarten angewendet werden kann.

Der Strahlungsheizer kann auch mittels eines Elektronenstrahls erhitzt werden. Nachteilig wirken sich hierbei allerdings die bereits erwähnten hohen Kosten der Elektronenstrahleinrichtungen aus.

Eine weitere Alternative für das Erhitzen des Verdampfungsmaterials beim erfindungsgemäßen Verfahren besteht darin, das erzeugte Plasma gleichzeitig für das Verdampfen des Ausgangsmaterials zu verwenden.

Bei einer Ausführungsform wird zwischen der Verdampfungseinrichtung und dem Substrat eine Abdeckung derart in der Sichtlinie angeordnet, dass der aufsteigende Dampf nicht geradlinig vom Verdampfungsgefäß zur Bedampfungszone auf dem zu beschichtenden Substrat aufsteigen kann, sondern erst die Abdeckung seitlich passieren muss. Dadurch vermeidet man, dass Spritzer aus dem erhitzten Verdampfungsmaterial auf das Substrat treffen.

Zwischen der Verdampfungseinrichtung und dem Substrat kann weiterhin ein Wärmeschild angeordnet werden, um die thermische Substratbelastung zu senken.

In den Prozessraum können auch zusätzliche Gase geleitet werden, um eine weitere Beeinflussung des Abscheideprozesses vorzunehmen. Dies können zum Beispiel bekannte Verfahrensschritte zum Regeln des Prozessdruckes sein. Dadurch ist eine Beeinflussung der Schichthomogenität, -porosität und -topographie möglich.

Außerdem kann auch die Verdampfungsrate geregelt werden, um über einen langen Prozesszeitraum konstante Schichtdicken zu erzielen.

Mit dem erfindungsgemäßen Verfahren abgeschiedene Schichten sind besonders geeignet für die Verwendung als Festkörperelektrolyt-Schichten für Batterien und Akkumulatoren.

### Ausführungsbeispiel

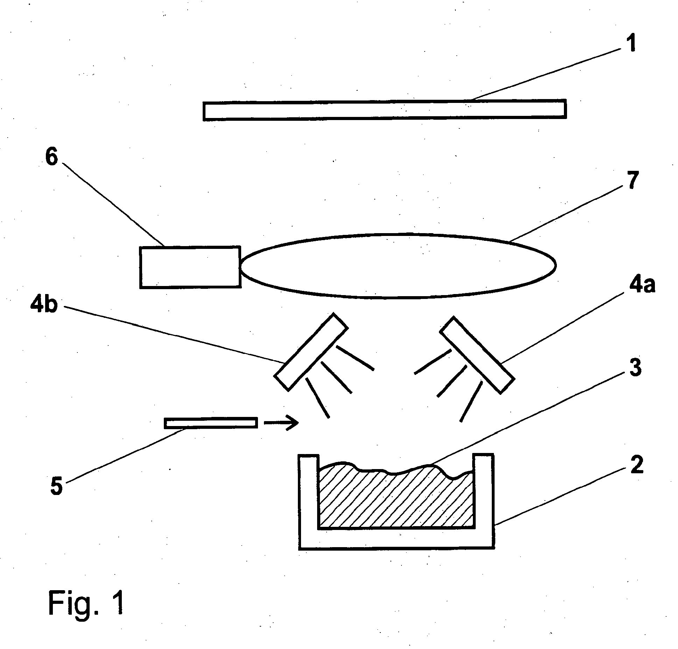

Die Erfindung wird nachfolgend anhand eines Ausführungsbeispiels näher erläutert. Fig. 1 zeigt eine schematische Darstellung einer Vorrichtung zum Ausführen des erfindungsgemäßen Verfahrens. In einer in Fig. 1 nicht dargestellten Vakuumkammer soll auf einem bandförmigen Polymerfolien-Substrat 1 eine LiPON-Schicht abgeschieden werden. Dazu wird das Substrat 1 mit einer Bandgeschwindigkeit von 1 m/min durch die Vakuumkammer hindurch bewegt. Unterhalb des Substrates 1 ist ein Graphittiegel 2 angeordnet, in dem sich LiPO-Granulat als Verdampfungsmaterial 3 befindet. Oberhalb des Graphittiegels 2 sind zwei Strahlungsheizer 4a und 4b derart angeordnet, dass deren Emissionsrichtung in Richtung des Verdampfungsmaterials 3 weist. Die Strahlungsheizer 4a, 4b werden mit einer Heizleistung von jeweils 15 kW betrieben, infolgedessen das im Graphittiegel 2 befindliche LiPO erhitzt und schließlich verdampft wird. Durch einen Einlass 5, der in vertikaler Richtung betrachtet zwischen dem Graphittiegel 2 und den Strahlungsheizern 4a, 4b angeordnet ist, wird das Reaktivgas Stickstoff mit 1000 sccm in die Vakuumkammer eingelassen. Zwischen den Strahlungsheizern 4a, 4b und dem Substrat 1 befindet sich eine als Hohlkathode ausgebildete Plasmaquelle 6, die infolge einer mit 150 A Entladungsstrom betriebenen Hohlkathodenbogenentladung ein Plasma 7 erzeugt, welches die vom Verdampfungsmaterial 3 aufsteigende Dampfpartikelwolke durchdringt. Die LiPO-Dampfpartikel werden durch das Plasma aktiviert und zur Reaktion mit dem in die Vakuumkammer eingelassenen Stickstoff angeregt, infolgedessen eine LiPON-Schicht mit einer Schichtdicke von 500 nm auf der Unterseite des Substrates 1 abgeschieden wird.

Die Schichtdicke der auf dem Substrat 1 abgeschiedenen LiPON-Schicht kann beispielsweise über die Bandgeschwindigkeit und/oder die Leistung der Strahlungsheizer eingestellt werden, wobei das Verringern der Bandgeschwindigkeit und das Erhöhen der elektrischen Leistung der Strahlungsheizer jeweils zum Erhöhen der Schichtdicke führen.

## Patentansprüche

1. Verfahren zum Abscheiden einer LiPON-Schicht auf einem Substrat (1), wobei das sich in einem Gefäß (2) befindende Verdampfungsmaterial (3), welches mindestens die chemischen Elemente Lithium, Phosphor und Sauerstoff umfasst, innerhalb einer Vakuumkammer verdampft wird, wobei LiPO-Granulat als Verdampfungsmaterial (3) mittels mindestens eines Strahlungsheizers (4a; 4b) erhitzt wird und gleichzeitig entweder eine stickstoffhaltige Komponente in die Vakuumkammer eingelassen wird oder ein stickstoffhaltiges Material co-verdampft wird und wobei die vom Gefäß (2) aufsteigende Dampfpartikelwolke vor dem Abscheiden auf dem Substrat von einem Plasma (7) durchdrungen wird.

2. Verfahren nach Anspruch 1, **dadurch gekennzeichnet, dass** eine Hohlkathodenbogenentladung zum Erzeugen des Plasmas verwendet wird.

3. Verfahren nach Anspruch 1, **dadurch gekennzeichnet, dass** eine magnetfeldüberlagerte Glimmentladung zum Erzeugen des Plasmas verwendet wird.

4. Verfahren nach Anspruch 1, **dadurch gekennzeichnet, dass** eine Mikrowelle zum Erzeugen des Plasmas verwendet wird.

5. Verfahren nach einem der vorhergehenden Ansprüche, **dadurch gekennzeichnet, dass** die Energiezufuhr zur Plasma erzeugenden Einrichtung gepulst erfolgt.

6. Verfahren nach einem der vorhergehenden Ansprüche, **dadurch gekennzeichnet, dass** als stickstoffhaltige Komponente ein stickstoffhaltiges Reaktivgas in die Vakuumkammer eingelassen wird.

7. Verfahren nach Anspruch 6, **dadurch gekennzeichnet, dass** Stickstoff, Ammoniak oder Lachgas als Reaktivgas verwendet wird.

## Claims

1. Method for depositing a LiPON layer on a substrate (1), wherein the evaporation material (3) that is located in a vessel (2) and comprises at least the chemical elements lithium, phosphorous, and oxygen is evaporated within a vacuum chamber, wherein the LiPON granulate as the evaporation material (3) is heated by means of at least one radiation heater (4a; 4b) and simultaneously either a nitrogen-containing component is admitted to the vacuum chamber or a nitrogen-containing material is conjointly evaporated, and wherein the vapour-particle cloud that rises from the vessel (2) prior to depositing on the substrate is penetrated by a plasma (7).

2. Method according to Claim 1, **characterized in that** a hollow cathode arc discharge is used for generating the plasma.

3. Method according to Claim 1, **characterized in that** a magnetic-field superimposed glow discharge is used for generating the plasma.

4. Method according to Claim 1, **characterized in that** a microwave is used for generating the plasma.

5. Method according to one of the preceding claims, **characterized in that** the energy supply to the plasma-generating installation is carried out in a pulsed manner.

6. Method according to one of the preceding claims, **characterized in that** a nitrogen-containing reactive gas is admitted as the nitrogen-containing component to the vacuum chamber.

7. Method according to Claim 6, **characterized in that** nitrogen, ammonia, or nitrous oxide is used as the reactive gas.

## Revendications

1. Procédé de dépôt d'une couche de LiPON sur un substrat (1), le produit de vaporisation (3) qui se trouve dans un récipient (2) et qui comprend au moins les éléments chimiques lithium, phosphore et oxygène, étant vaporisé à l'intérieur d'une chambre à vide, des granulés de LiPON en tant que produit de vaporisation (3) étant chauffés au moyen d'au moins un élément chauffant à rayonnement (4a ; 4b), et simultanément soit un composant contenant de l'azote est introduit dans la chambre à vide, soit un produit contenant de l'azote est vaporisé conjointement, et le nuage de particules de vapeur s'élevant à partir du récipient (2) étant traversé par un plasma (7) avant le dépôt sur le substrat.

2. Procédé selon la revendication 1, **caractérisé en ce qu'**une décharge d'arc à cathode creuse est utilisée pour produire le plasma.

3. Procédé selon la revendication 1, **caractérisé en ce qu'**une décharge luminescente superposée à un champ magnétique est utilisée pour produire le plasma.

4. Procédé selon la revendication 1, **caractérisé en ce qu'**une micro-onde est utilisée pour produire le plasma.

5. Procédé selon l'une des revendications précédentes, **caractérisé en ce que** l'amenée d'énergie au dispositif produisant le plasma s'effectue de façon pulsée.

6. Procédé selon l'une des revendications précédentes, **caractérisé en ce que**, en tant que composant contenant de l'azote, un gaz réactif contenant de l'azote est introduit dans la chambre à vide.

7. Procédé selon la revendication 6, **caractérisé en ce que** de l'azote, de l'ammoniac ou du protoxyde d'azote est utilisé en tant que gaz réactif.
